Europäisches Patentamt

(19) European Patent Office

Office européen des brevets

(11) Publication number : **0 493 640 B1**

# (12) EUROPEAN PATENT SPECIFICATION

(45) Date of publication of patent specification :
**19.04.95 Bulletin 95/16**

(51) Int. Cl.⁶ : **H01L 29/788, H01L 27/115**

(21) Application number : **90830622.8**

(22) Date of filing : **31.12.90**

(54) **EEPROM cell with single metal level gate having a (read) interface toward the external circuitry isolated from the (write/erase) interface toward the programming circuitry.**

(43) Date of publication of application :
**08.07.92 Bulletin 92/28**

(45) Publication of the grant of the patent :
**19.04.95 Bulletin 95/16**

(84) Designated Contracting States :
**DE FR GB IT NL SE**

(56) References cited :
**EP-A- 0 268 315
EP-A- 0 272 732
EP-A- 0 347 148**

(73) Proprietor : **SGS-THOMSON
MICROELECTRONICS s.r.l.
Via C. Olivetti, 2
I-20041 Agrate Brianza (Milano) (IT)**

(72) Inventor : **Villa, Nuccio
Via del Guadagno, 23
I-20040 Roncello (IT)**

(74) Representative : **Pellegri, Alberto et al
c/o Società Italiana Brevetti S.p.A.
Via Puccini, 7
I-21100 Varese (IT)**

## Description

The present invention relates to an EEPROM memory cell with single level of gate metallization, having an interface toward the programming circuitry which is substantially isolated electrically from other interfaces of the memory cell toward an external circuitry.

The structure of an EEPROM memory cell with a single level of gate metallization, which is frequently constituted by a polycrystalline silicon layer (single poly) though it may also be constituted by an aluminum or aluminum alloy layer, may be schematically depicted as the structure of a MOS transistor, commonly an n-channel, isolated-gate transistor, wherein the control terminal is capacitively coupled to the isolated gate. The isolated gate is fundamentally and physically contoured over two zones: a thin tunnel-oxide zone, through which the basic electrical phenomena of the writing and erasing mechanisms of the memory cell occur, and a relatively thicker oxide zone, over which the isolated gate acts as the gate of a "read" transistor for reading the state or the data stored in the memory cell.

The document EP-A-0 272 732 discloses an EEPROM memory cell structure having an isolated control gate diffusion for allowing bit by bit erasing/writing. The document EP-A-0 268 315 discloses an EEPROM memory cell structure wherein the tunnelling area is isolated from the active area of the memory cell and of the selection and detection transistors. The document EP-A-0 347 148 discloses an EEPROM memory cell with a single level gate structure, employing a control gate electrode in the form of a diffused region, capacitively coupled to the floating gate of the cell through a gate oxide film.

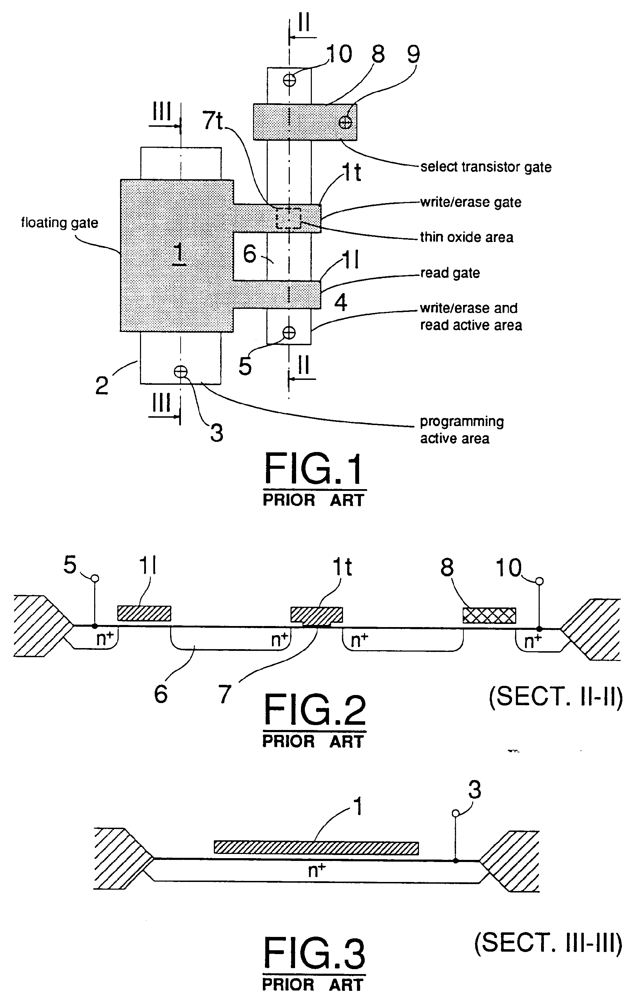

This typical structure of the known art according to the preamble of claim 1, is depicted schematically in **Figures 1**, **2** and **3**. The isolated gate 1 lies over a programming first active area 2 of the semiconducting substrate in order to form a capacitive coupling zone between the same isolated gate 1 and a control terminal 3. The isolated gate 1 has a first projection it and a second projection 11, both extending over a second active area 4. In this second active area, the relative diffusions for creating a "read", n-channel, MOS transistor are formed, the drain terminal (contact) of which being indicated with 5 and the source region with 6 in the figure. Also in this second active area 4 the capacitive coupling between the isolated gate structure with a zone 7 of the semiconducting substrate which is covered with a thin, dielectric, tunnelling layer, essentially thinner than the dielectric gate layer which is present over the rest of the area 4, is realized. Moreover, as shown in Figures 1 and 2, within the same second active area 4, an n-channel select transistor is also commonly formed, the gate of which is indicated with 8 and the relative control terminal with 9 (**Fig. 1**) and whose source terminal is indicated with 10.

The fact that the gate 11 of the "read" transistor is formed on the same active area 4 over which the writing/erasing gate 1t is also formed, creates precise limitations and nonnegligeable drawbacks. In these known cells, relatively low voltages must be maintained across the "read" gate of the cell, i.e. between the source and the drain regions (6 and 5) of the read transistor of the cell, in order to prevent an unintentional modification of the programmed or erased state of the memory cell. In fact, by being the read transistor's gate 11 formed within the same active area 4 of the write/erase tunnelling zone 7, any voltage across these regions is replicated in the write/erase gate zone and this voltage determines an electric field across the tunneling thin dielectric layer 7 given by:

$$\frac{V_{isolated\,gate} - V_{drain\,of\,the\,write\,gate}}{thickness\,of\,the\,tunnel\,dielectric} = \frac{V(1) - V(6)}{thickness\,(7)}$$

If not appropriately limited, this electric field may determine a reverse voltage value sufficient to program an erased cell or to erase a programmed cell, thus causing erroneous responses of the memory device.

These restraints on the voltage levels which may be safely used in reading the data stored in the memory cell, i.e. of the voltage levels which may be used at the interface of the memory cell toward the external circuitry, disadvantageously limit the use of the memory cell as a modular element capable of being coupled directly with other CMOS structures of the circuitry outside the memory section of the integrated circuit. On the contrary, this makes necessary to operate with relatively small amplitude signals and to add signal level regenerating stages "downstream" of the EEPROM cells, thus increasing the signal propagation times and the power consumption of the integrated circuit.

## SUMMARY OF THE INVENTION

In view of this state of the art, the present invention provides an EEPROM cell with a single level of gate metallization, having an interface toward the programming circuitry which is electrically isolated from other interfaces of the cell toward an external circuitry. In this way the implementation of a logic function by operating the cell or the cells at voltage and current levels of normal CMOS circuitry may be realized through the same isolated gate of the memory cell.

Basically the EEPROM cell of the invention comprises an isolated gate structure which is formed by a first portion which extends over a first active area of a semiconducting substrate covered by a gate dielectric layer, and which may be capacitively coupled to a certain control terminal of the cell; by a second portion which extends over a second active area, which is substantially isolated from the first active area and is covered, over at least a first portion of area underneath said second portion of the isolated gate with a tunnelling dielectric layer which is essentially thinner than said dielectric gate layer; and the isolated gate has at least a third portion which extends over at least a first portion of a third active area, substantially isolated from said first and said second active areas and which is covered with a dielectric gate layer and constitutes the gate of at least a first "read" transistor of the state of the memory cell.

The same isolated gate of the memory cell may have a further projection extending over a fourth active area having a type of conductivity complementary to the type of conductivity of the other three active areas mentioned before, in order to form a second "read" transistor of the state of the memory cell of a complementary type in respect to the first read transistor. This latter embodiment, as will be discussed later, provides an interface which is advantageously configured as a CMOS inverter and permits to implement an important enabling and reset logic function in an extremely simple and effective manner by employing a single memory cell, with remarkable advantages in terms of speed of propagation and of area occupation.

Even though on a same active area two or more extensions of the isolated gate may be formed for realizing as many read transistors, isolated from the programming circuitry of the cell, this solution, although possible, has a relatively limited utility.

*BRIEF DESCRIPTION OF THE DRAWINGS*

The different aspects and advantages of the invention will become evident through the following detailed description of some preferred embodiments of the invention and by reference to the drawings, wherein:

**Figure 1** is a schematic plan view of the structure of an EEPROM cell, according to the prior art;

**Figure 2** is a simplified view in cross section of the structure of Fig. 1, on the section plane II-II;

**Figure 3** is a simplified cross sectional view of the integrated structure of Fig. 1, on the section plane III-III;

**Figure 4** is a schematic plan view of the integrated structure of an EEPROM memory cell with a single level of gate metallization, made in accordance with the present invention;

**Figure 5** is a simplied cross sectional view of the structure of Fig. 4 on the sectional plane IV-IV;

**Figure 6** is a simplified cross sectional view of the integrated structure of Fig. 4, on the sectional plane V-V;

**Figure 7** is a simplified cross sectional view of the integrated structure of Fig. 4, on the sectional plane VI-VI;

**Figure 8** is a schematic plan view of an alternative embodiment of the integrated structure of an EEPROM memory cell of the invention;

**Figure 9** is a functional block diagram of a logic circuit for generating a product term by employing EEPROM cells, acto a prior known technique;

**Figure 10** is a block diagram of a logic circuit functionally equivalent to the circuit of Fig. 9, realized in CMOS technology, in accordance with the prior art;

**Figure 11** is a partial block diagram of the enable circuit section of the functional diagram of Fig. 10, realized by using EEPROM cells having a conventional structure, in accordance with a known technique;

**Figure 12** is a further functional block diagram showing in greater detail the portion for the generation of the enable and selection signals for a single input of the circuit of Fig. 10;

**Figure 13** is a circuit diagram, functionally equivalent to the circuit of Fig. 12, realized by using EEPROM cells made in accordance with the present invention, in the form depicted in Fig. 8;

**Figure 14** is a functional, schematic plan view of the integrated structure of an EEPROM cell of the invention;

**Figure 15** represents an equivalent circuit diagram of the integrated structure of Fig. 14;

**Figure 16** is a schematic representation of the functional diagram of a multiplexing array, i.e. of a programmable interconnection array made with EEPROM cells of the present invention.

*DESCRIPTION OF PREFERRED EMBODIMENTS*

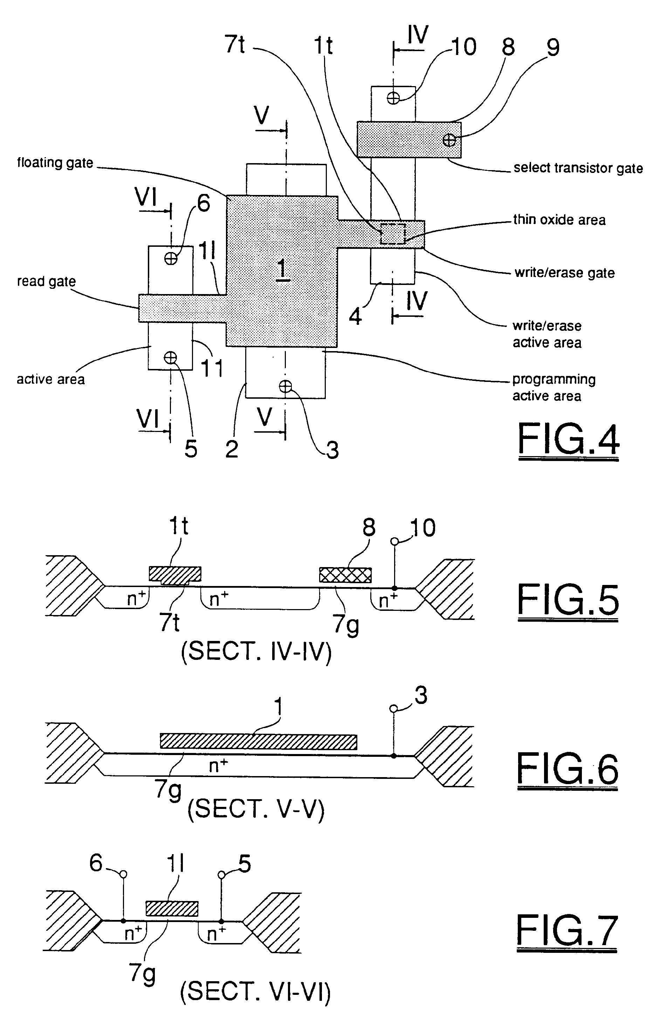

With reference to **Figures 1** to **8**, in the **Figures 4, 5, 6, 7** and **8**, which depict two alternative embodiments of the EEPROM cell of the invention, the same numbers already used in the preceding **Figure 1, 2** and **3** have been used for indicating similar or functionally equivalent parts of the integrated structures, with the purpose of facilitating a comparison among the different features of the cell of the invention and the features of a known cell, which has been already described in the preceding background section of the present specification.

With reference to **Figures 4, 5, 6** and **7**, the isolated gate 1 has a projection 11 constituting a so-called "read gate" of the memory device, which does not extend over the same active area 4, as was the case in the structure of an EEPROM cell of the prior art, but on the contrary the read gate 11 extends over a third active area 11, within which respective source and drain regions are formed in the underlying semiconducting substrate and which are contacted through the contacts 5 and 6, respectively of drain and source. The write/erase region, belonging to the active area 4, within which also the "select" transistor is formed in a manner similar to that of an EEPROM cell of the prior art, is clearly separated from the region of the read transistor which is made within the active area 11 and the gate structure of which may be designed in a manner completely free of restraints which would be imposed otherwise by the programming circuitry which advantageously interfaces with the active area 4, and thus may function at voltage and current levels compatible with those of a normal CMOS external circuitry. In fact the capacitive coupling of the isolated gate 1 toward the external circuitry is dramatically reduced for what concerns the tunnelling zone 7t where the thin dielectric layer 7 is present and where the previously mentioned problems may occur. The tunnelling zone is within the active area 4, which represents the interface region with the programming circuitry of the memory cell.

The active area 11 represents instead the interface region between the cell and the external circuits and, in practice, is substantially isolated electrically toward the other programming circuitry interface region. In fact even though, through the gate structure of the read transistor, a capacitive coupling with the zone 7t of the write/erase thin dielectric layer exists through the same isolated gate 1, this coupling occurs through a dielectric layer having a thickness from three to four times greater then the thickness of the thin dielectric layer 7 which is present in the tunnelling area 7t and therefore the electric field intensity is reduced by a similar factor for the same biasing voltage and may be neglected. In any case, the choice of the most suitable biasing voltage for the control terminal 3 remains possible in order to balance the coupling with the gate of the read transistor and thus preserve the electric state of the memory cell, during a reading phase.

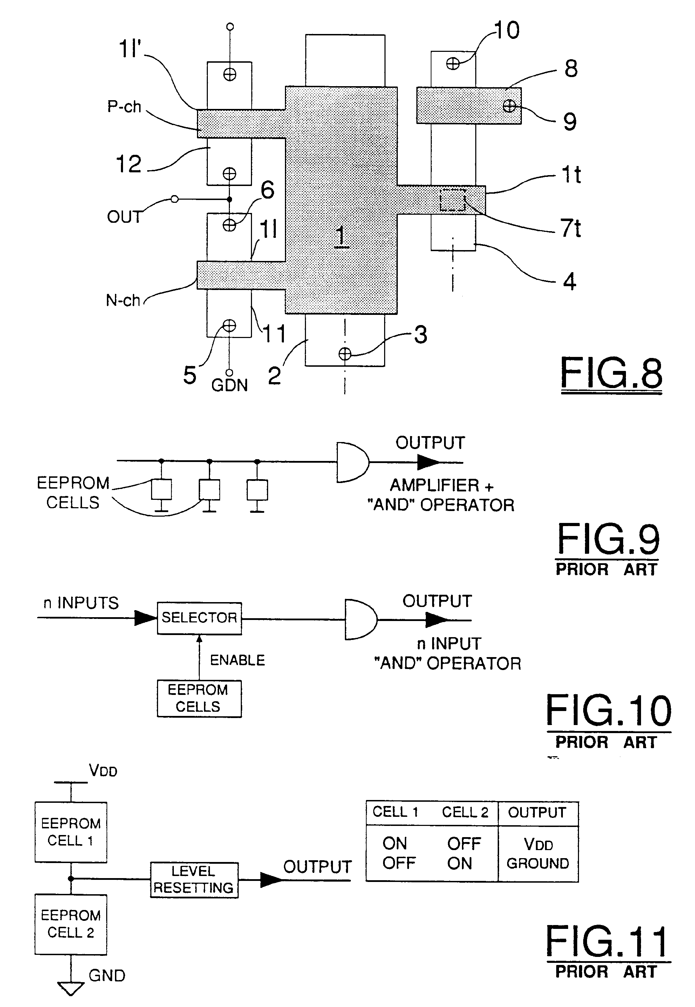

Probably the most remarkable aspect of the structure of the EEPROM memory cell of the present invention is represented by the possibility of differentiating the electrical characteristics of the read transistor of the cell according to need, as well as by the possibility of realizing more than one read transistors each having electrical characteristics different from the others. Among these alternative embodiments, a particularly preferred embodiment is the one shown in **Fig. 8**. According to this embodiment, the isolated gate 1 is provided with another projection 11' extending over a fourth active area 12 which has been provided with a conductivity of opposite type in respect to the type of conductivity of the active area 11. By forming the respective source and drain diffusions, two distinct and complementary read transistors: of the memory cell are formed one with an n-channel and the other with a p-channel. By connecting the respective terminals of the pair of complementary transistors in the manner shown in **Fig. 8**, a "read interface" toward the external circuitry is obtained, which is substantially configured as a CMOS inverter. This type of read interface lends itself to very convenient circuital applications, as will be described later.

Under more general terms, the EEPROM memory cell of the invention lends itself to an extraordinarily large number of applications, as will be evident to a skilled person.

*APPLICATION 1*

A logic function which is often implemented in integrated devices is the generation of a product term by employing individually addressable and programmable EEPROM cells organized in an array of rows and columns and analog circuits (sense amplifiers) with the function of amplifying the weak read signals of the EEPROM cells which have an amplitude in the order of ten milllivolts, coming from the array. These integrated architectures, though being quite compact from the point of view of silicon area occupation, denounce a large power consumption and a remarkable delay in the regeneration to CMOS logic levels of the read signals derived from the array of EEPROM cells. **Fig. 9** shows a functional block diagram of such a circuit.

In **Fig. 10** is shown a block diagram relative to a sample implementation of the functions of the circuit of **Fig. 9** in a CMOS type device. The parts which are pertinent to the function of enabling the selector may be generically made by employing conventional type EEPROM cells according to various circuital arrangements which are well known to a skilled technician, among which the most typical arrangement is a voltage divider using two EEPROM cells, as depicted in **Fig. 11** which also contains the relative logic operation table.

In a CMOS device, an embodiment of the type shown in Fig. 11, using two n-channel EEPROM cells, has the drawback of producing an output high level of a lower value than the supply voltage and more precisely lower by a threshold value then the voltage which is present on the isolated gate of the memory cell 1, i.e.:

$$V_{output} = V_{(gate\ of\ cell\ 1)} - V_{threshold}.$$

This voltage divider structure is extremely critical because the output signal may be degenerated and insufficient to drive CMOS circuits downstream. It is therefore necessary to add, downstream of the divider, a level regenerating stage in order to reduce this criticality. These restraints impose severe limits on programming quality and may cause a remarkable decrease of the fabrication yield. Moreover for each enable signal, two EEPROM cells and a relative level regenerating stage for the voltage signal are needed, i.e. in practice a "redundant" circuit stage as compared to strict functional needs.

By employing a single EEPROM memory cell of the invention, of the type depicted in **Fig. 8**, the memory function and the auxiliary function of regenerating the voltage level of the logic signal may be implemented in a combined manner. In fact the OUT terminal of the EEPROM cell of the invention described in **Fig. 8**, may represent the output terminal of the functional scheme of **Fig. 11**, while the respective source terminal of the p-channel read transistor may be directly connected to the supply rail $V_{DD}$ and the source terminal 5 of the n-channel read transistor may be connected to ground (GDN).

By suitably dimensioning the CMOS inverter constituted by the pair of complementary read transistors of the EEPROM cell (naturally provided with two read gates: 11 and 11') the required functions are practically implemented.

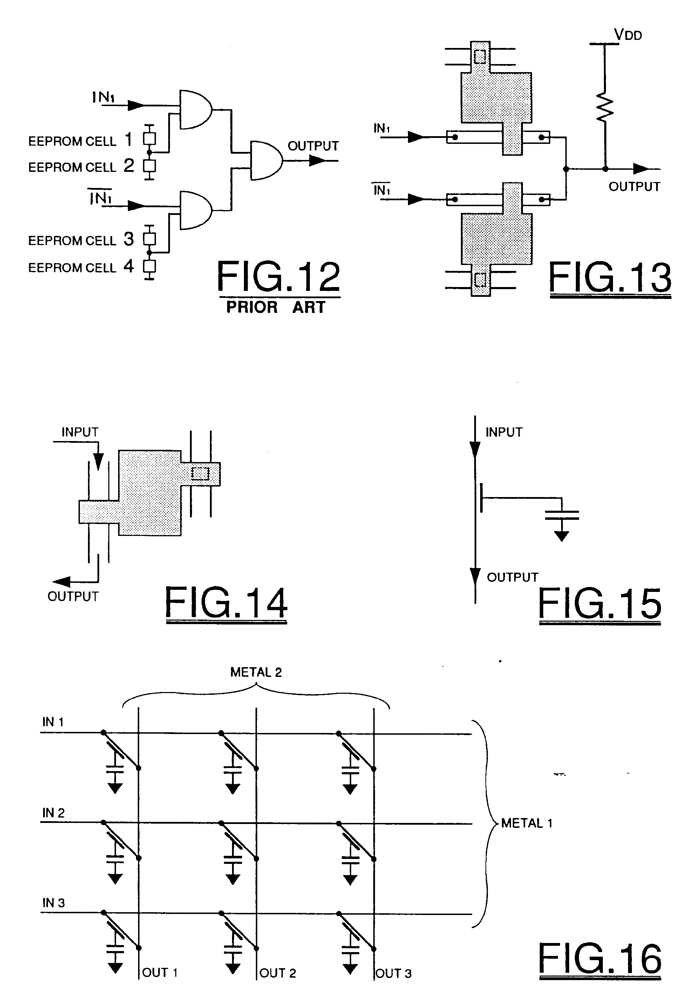

**Fig. 12** shows in greater detail the circuit portion for the generation of the enable and selection signals for a single input of the circuit of **Fig. 10**. Of course this structure is replicated as many times as the number of inputs.

The same functions are implemented by using only two EEPROM cells of the invention, of the type shown in **Fig. 4**, for driving through the respective output terminal (OUTPUT) of the memory cell a circuit which implements the logic AND operator, according to the diagram shown in **Fig. 13**.

By using the EEPROM cells of the invention, a redundancy in the total number of cells may be eliminated (two cells instead of four), thus realizing a remarkable saving of occupied area (two transistors instead of twelve, as would be necessary according to the diagram of **Fig. 12**, as will be evident to a skilled technician) and there will be a propagation delay imputable to a single transmission gate instead of the sum of propagation delays of two logic AND gates.

*APPLICATION 2*

A single EEPROM cell made in accordance with the present invention may be functionally represented in a schematic way by the simplified integrated structure depicted in **Fig. 14**. To this structure corresponds the functional electric circuit shown in **Fig. 15**. The EEPROM cell of the invention is particularly suited to act as an EEPROM interconnecting element within complex programmable integrated devices. The cell is in fact capable of simultaneously perform a memory function and the function of a switch, the latter being perfectly suited to operate with voltage levels which are compatible with a standard CMOS circuitry. Therefore the EEPROM cell of the invention possesses an outstanding utility for implementing multiplexing structures or programmable interconnection arrays. A functional scheme of such an array of EEPROM cells of the invention is depicted in **Fig. 16**. A programmable interconnection array may be schemed in a first order of parallel conducting lines, patterned through a first level metal layer (metal 1), each corresponding to a respective input of the array and in a second order of parallel conducting lines, electrically isolated from the conducting lines of the first order, orthogonally arranged over the conducting lines of the first order, commonly patterned through a second level metal layer (metal 2), each corresponding to a respective output of the array. At every crossing between a conducting line of the first order (input line) and a conducting line of the second order (output line) there is a programmable connection device, which is advantageously constituted by an EEPROM cell of the invention. The connection element is constituted by the read transistor of the state of the programmable memory cell, the source and drain terminals of which are respectively connected to a conducting line of the first order (to an input) and to a conducting line of the second order (to an output), or viceversa. As already described before, this read transistor of the EEPROM cell made in accordance with the present invention may advantageously be sized so as to withstand voltage and current levels which are compatible with the levels of a logic circuit external to the interconnection array, by being substantially isolated from the programming active area of the memory cell.

**Claims**

1. An EEPROM memory cell with a single level gate structure, comprising an isolated gate member (1) of conducting material having a first portion that constitutes a floating gate of said memory cell extending over a first active area (2) of a semiconducting substrate covered with a dielectric gate layer (7g) for establishing a capacitive coupling with a control terminal (3) of the cell, a second portion (1t) extending over a second active area (4), isolated from said first active area (2) and covered over at least a portion of the area underneath said second portion (1t) of the isolated gate member (1) with a dielectric tunnel layer (7t) essentially thinner than said dielectric gate layer (7g),

   characterized by the fact that
   said isolated gate member (1) has at least a third portion (11) which extends over at least a first portion of a third active area (11) covered with a dielectric gate layer (7g) and which is isolated from said first active area (2) and from said second active area (4), said third portion (1l) of the isolated gate member (1) constituting the gate of at least a first transistor.

2. The EEPROM cell according to claim 1, wherein said isolated gate member (1) has a fourth portion (11') which extends over a fourth active area (12) covered with a dielectric gate layer (7g) and which is isolated from said other active areas (11, 4, 2) and said fourth portion (1l') constitutes the gate of a second transistor, complementary to said first transistor.

3. The EEPROM cell according to claim 1, wherein over a portion of said second active area (4), covered with a dielectric gate layer (7g), extends a gate (8) of a select transistor.

4. A logic circuit formed on a semiconducting substrate and employing EEPROM memory cells with a single level gate structure, which are individually addressable and programmable,
   characterized by the fact that
   each EEPROM memory cell has a structure as defined in claims 1 or 2, said second active area (4) constituting an interface zone with an addressing and programming circuitry, isolated from said third (11) and fourth (12) active areas constituting interface zones with a logic circuitry.

5. A logic circuit as defined in claim 4, wherein said interface with a logic circuitry is structured as a CMOS inverter stage.

6. A programmable interconnection array comprising a first order of parallel conducting lines, each being connected to a respective input of the array, and a second order of parallel conducting lines, electrically isolated from and orthogonally arranged over said conducting lines of the first order, each line of the second order being connected to a respective output of the array, programmable electrical connection means between each line of said first order and each line of said second order at every crossing between each line of the first order and each line of the second order,
   characterized by the fact that
   each of said programmable electrical interconnection means is realized with an EEPROM cell having a structure as defined in claim 1, said second active area (4) constituting an interface zone with an addressing and programming circuitry, isolated from said third (11) active area and wherein said transistor constitutes a switch set by the state of said EEPROM cell.

**Patentansprüche**

1. EEPROM-Speicherzelle mit einer Einzelschicht-Gatestruktur umfassend ein isoliertes Gateelement (1) aus leitendem Material mit einem ersten Abschnitt, der ein schwimmendes Gate der Speicherzelle bildet, die sich über eine erste aktive Zone (2) eines Halbleitersubstrats erstreckt, welches mit einer dielektrischen Gateschicht (7g) bedeckt ist, um eine kapazitive Kopplung mit einem Steueranschluß (3) der Zelle zu schaffen, mit einem zweiten Abschnitt (lt), der sich über eine zweite aktive Zone (4) erstreckt, die von der ersten aktiven Zone (2) getrennt ist und über zumindest einem Abschnitt der Zone unterhalb des zweiten Abschnitts (lt) des isolierten Gateelements (1) mit einer dielektrischen Tunnelschicht (7t) überzogen ist, die wesentlich dünner ist als die dielektrische Gateschicht (7g),
   **dadurch gekennzeichnet, daß**
   das isolierte Gateelement (1) mindestens einen dritten Abschnitt (11) besitzt, der sich über mindestens einen ersten Abschnitt einer dritten aktiven Zone (11) erstreckt, die mit einer dielektrischen Gateschicht (7g) bedeckt ist, und die von der ersten aktiven Zone (2) und von der zweiten aktiven Zone (4) getrennt ist, wobei der dritte Abschnitt (1l) des isolierten Gateelements (1) das Gate mindestens eines ersten Transistors bildet.

2. EEPROM-Zelle nach Anspruch 1, bei der das isolierte Gateelement (1) einen vierten Abschnitt (11') aufweist, der sich über eine vierte aktive Zone (12) erstreckt, die mit einer dielektrischen Gateschicht (7g) überzogen ist, und die von den andern aktiven Zonen (11, 4, 2) getrennt ist, wobei der vierte Abschnitt (11') das Gate eines zweiten, zu dem ersten Transistor komplementären Transistors bildet.

3. EEPROM-Zelle nach Anspruch 1, bei der über einem Abschnitt der zweiten aktiven Zone (4), die mit einer dielektrischen Gateschicht (7g) bedeckt ist, sich ein Gate (8) eines Auswahltransistors erstreckt.

4. Logikschaltung, gebildet aus einem halbleitenden Substrat unter Verwendung von EEPROM-Speicherzellen mit einer Einzelschicht-Gatestruktur, die individuell adressierbar und programmierbar sind,
   **dadurch gekennzeichnet, daß**
   jede EEPROM-Speicherzelle eine Struktur gemäß Anspruch 1 oder 2 aufweist, daß die zweite aktive Zone (4) eine Schnittstellenzone bezüglich einer Adressier- und Programmierschaltung bildet, die von der dritten (11) und der vierten (12) aktiven Zone getrennt ist, welche Schnittstellenzonen bezüglich einer Logikschaltung bilden.

5. Logikschaltung nach Anspruch 4, bei der die Schnittstelle bezüglich einer Logikschaltung als CMOS-Invertierstufe ausgebildet ist.

6. Programmierbares Verbindungsfeld, umfassend eine erste Folge paralleler leitender Leitungen, die jeweils mit einem zugehörigen Eingang des Feldes verbunden sind, und eine zweite Folge paralleler leitender Leitungen, die elektrisch von den leitenden Leitungen der ersten Folge getrennt und zu diesen orthogonal angeordnet sind, wobei jede Leitung der zweiten Folge mit einem zugehörigen Ausgang des Feldes verbunden ist, eine programmierbare elektrische Verbindungsanordnung zwischen jeder Leitung der ersten Folge und jeder Leitung der zweiten Folge an jeder Kreuzungsstelle zwischen jeder Leitung der ersten Folge und jeder Leitung der zweiten Folge, **dadurch gekennzeichnet,** jede der programmierbaren elektrischen Verbindungseinrichtungen durch eine EEPROM-Zelle realisiert ist, die eine Struktur gemäß Anspruch 1 aufweist, die zweite aktive Zone (4) eine Schnittstellenzone bezüglich einer Adressier- und Programmierschaltung bildet, getrennt von der dritten (11) aktiven Zone, wobei der Transistor einen Schalter bildet, welcher durch den Zustand der EEPROM-Zelle eingestellt wird.

**Revendications**

1. Cellule mémoire EEPROM à un seul niveau de structure de grille, comprenant un élément de grille isolé (1) en matériau conducteur ayant une première partie qui constitue une grille flottante de la cellule mémoire s'étendant au-dessus d'une première zone active (2) d'un substrat semiconducteur recouvert d'une couche diélectrique de grille (7g) pour établir un couplage capacitif avec une borne de commande (3) de la cellule, une deuxième partie (lt) s'étendant au-dessus d'une deuxième zone active (4), isolée de la première zone active (2) et recouverte sur au moins une partie de la zone sous la deuxième partie (lt) de l'élément de grille isolé (1) d'une couche diélectrique tunnel (7t) sensiblement plus mince que la couche diélectrique de grille (7g), caractérisée en ce que l'élément de grille isolé (1) a au moins une troisième partie (11) qui s'étend au-dessus d'au moins une première partie d'une troisième zone active (11) recouverte d'une couche diélectrique de grille (7g) et qui est isolée de la première zone active (2) et de la deuxième zone active (4), la troisième partie (11) de l'élément de grille isolé (1) constituant la grille d'au moins un premier transistor.

2. Cellule EEPROM selon la revendication 1, dans laquelle l'élément de grille isolé (1) a une quatrième partie (11') qui s'étend au-dessus d'une quatrième zone active (12) recouverte d'une couche diélectrique de grille (7g) et qui est isolée des autres zones actives (11, 4, 2), cette quatrième partie (11') constituant la grille d'un second transistor, complémentaire du premier transistor.

3. Cellule EEPROM selon la revendication 1, dans laquelle une grille (8) d'un transistor de sélection s'étend au-dessus d'une partie de la deuxième zone active (4), recouverte d'une couche diélectrique de grille (7g).

4. Circuit logique formé sur un substrat semiconducteur et utilisant des cellules mémoire EEPROM à un seul niveau de structure de grille, qui sont individuellement adressables et programmables, caractérisé en ce que chaque cellule mémoire EEPROM a une structure telle que définie dans les revendications 1 ou 2, la deuxième zone active (4) constituant une zone d'interface avec un circuit d'adressage et de programmation, isolée de la troisième (11) et de la quatrième (12) zone active constituant des zones d'interface avec un circuit logique.

5. Circuit logique selon la revendication 4, dans lequel l'interface avec un circuit logique a la structure d'un étage inverseur CMOS.

6. Réseau d'interconnexion programmable comprenant un premier ordre de lignes conductrices parallèles, chacune étant connectée à une entrée respective du réseau, et un second ordre de lignes conductrices parallèles, électriquement isolées des lignes conductrices du premier ordre et disposées orthogonalement au-dessus de celles-ci, chaque ligne du second ordre étant connectée à une sortie respective du réseau, des moyens de connexion électrique programmables entre chaque ligne du premier ordre et chaque ligne du second ordre à chaque croisement entre chaque ligne du premier ordre et chaque ligne du second ordre, caractérisé en ce que chacun des moyens d'interconnexion électrique programmables est constitué d'une cellule EEPROM ayant une structure telle que définie dans la revendication 1, la seconde zone active (4) constituant une zone d'interface avec un circuit d'adressage et de programmation, isolée de la troisième zone active (11) et en ce que ledit transistor constitue un commutateur commandé par l'état de la cellule EEPROM.

floating gate

select transistor gate

write/erase gate

thin oxide area

read gate

write/erase and
read active area

programming
active area

## FIG.1
### PRIOR ART

## FIG.2
### PRIOR ART

(SECT. II-II)

## FIG.3
### PRIOR ART

(SECT. III-III)

FIG.4

floating gate

read gate

active area

select transistor gate

thin oxide area

write/erase gate

write/erase active area

programming active area

FIG.5

(SECT. IV-IV)

FIG.6

(SECT. V-V)

FIG.7

(SECT. VI-VI)

1l'
P-ch
12
OUT
6
1l
N-ch
5
GDN
2
11
1
3
4
1t
7t
8
9
10

**FIG.8**

EEPROM CELLS

OUTPUT

AMPLIFIER + "AND" OPERATOR

**FIG.9**
PRIOR ART

n INPUTS

SELECTOR

ENABLE

EEPROM CELLS

OUTPUT

n INPUT "AND" OPERATOR

**FIG.10**
PRIOR ART

$V_{DD}$

EEPROM CELL 1

EEPROM CELL 2

GND

LEVEL RESETTING

OUTPUT

| CELL 1 | CELL 2 | OUTPUT |
|--------|--------|--------|
| ON | OFF | $V_{DD}$ |
| OFF | ON | GROUND |

**FIG.11**
PRIOR ART

IN₁

EEPROM CELL 1
EEPROM CELL 2

$\overline{IN_1}$

EEPROM CELL 3
EEPROM CELL 4

OUTPUT

# FIG.12
## PRIOR ART

V_DD

IN₁

$\overline{IN_1}$

OUTPUT

# FIG.13

INPUT

OUTPUT

# FIG.14

INPUT

OUTPUT

# FIG.15

METAL 2

IN 1

IN 2

IN 3

METAL 1

OUT 1        OUT 2        OUT 3

# FIG.16